# FASCICULE DE BREVET EUROPEEN

(11) **EP 3 408 869 B1**
(45) Date de publication et mention de la délivrance du brevet: **14.07.2021**
(21) Numéro de dépôt: 16720454.4
(22) Date de dépôt: 04.04.2016
(51) Int. Cl.: H02S 40/44, H01L 31/054

(54) **PANNEAU SOLAIRE PHOTOVOLTAÏQUE ET THERMIQUE**
FOTOVOLTAISCHES UND THERMISCHES SOLARPANEEL
PHOTOVOLTAIC AND THERMAL SOLAR PANEL

(30) Priorité: 03.04.2015 FR 1552907
(43) Date de publication de la demande: 05.12.2018
(73) Titulaire: Dualsun, 13453 Marseille Cedex 13 (FR)
(72) Inventeur: BROTTIER, Laetitia, 16380 Chazelles (FR); MOUTERDE, Jérôme, 13013 Marseille (FR)
(74) Mandataire: Roman, Alexis
(86) Numéro de dépôt international: PCT/FR2016/050765
(87) Numéro de publication internationale: WO 2016/156764

(56) Documents cités:
- WO-A1-2005/028967
- WO-A2-2008/003109
- WO-A2-2012/110758
- DE-A1- 10 102 918
- DE-A1-102005 024 516
- DE-U1- 20 010 880
- FR-A1- 2 070 910
- FR-A1- 2 510 733
- US-A1- 2012 024 283

## Description

### Domaine technique de l'invention.

L'invention a pour objet un panneau solaire photovoltaïque et thermique (hybride) ainsi que son procédé de fabrication.

Elle concerne le domaine technique des échangeurs thermiques pour le contrôle thermique de panneaux solaires hybrides.

### État de la technique.

Les panneaux solaires photovoltaïques permettent de produire une énergie électrique à partir du rayonnement solaire. Ils comprennent une pluralité d'éléments photovoltaïques (cellules ou couches minces) qui fonctionnent selon le principe de l'effet photoélectrique. Généralement, plusieurs éléments photovoltaïques sont reliés entre eux sur un panneau solaire photovoltaïque, et plusieurs panneaux sont reliés pour créer une installation solaire. Cette installation produit de l'électricité qui peut être consommée sur place ou alimenter un réseau de distribution.

Les panneaux solaires photovoltaïques ne convertissent qu'une faible part du rayonnement solaire en électricité, le reste étant de la chaleur non utilisée. Cette chaleur est défavorable à la performance électrique des panneaux solaires puisqu'on peut constater une diminution de l'efficacité des éléments photovoltaïques avec la température d'environ -0.45%/°C. C'est pourquoi il est doublement intéressant de refroidir les panneaux solaires photovoltaïques. En effet, non seulement l'efficacité des éléments photovoltaïques croît, mais les calories du refroidissement peuvent être utilisées dans des systèmes de chauffage plus ou moins complexes. On parle alors de panneaux solaires hybrides capables de produire simultanément une énergie électrique et une énergie thermique.

Généralement, un échangeur thermique est disposé en vis-à-vis de la face arrière du module photovoltaïque de façon à refroidir ce dernier. Le document brevet DE 101 02 918 (SCHULTZE-KRAFT ANDREAS) divulgue un tel échangeur pour un panneau solaire conventionnel qui n'est pas hybride.

Le document brevet WO 2012/069750 (SOLAIRE 2G) propose un panneau solaire hybride composé d'un échangeur thermique comprenant une zone d'échange thermique en contact avec les éléments photovoltaïques. Cette zone d'échange présente des éléments permettant de perturber l'écoulement d'un fluide de refroidissement. De fait, cette configuration nécessite une fabrication assez complexe de l'échangeur, augmentant par conséquent le coût du panneau solaire. De plus, l'échangeur est préférentiellement fabriqué en métal (inox) augmentant encore le coût ainsi que le poids du panneau.

Le document brevet EP 2.284.910 (ROTH WERKE GMBH) adresse partiellement les inconvénients précités. En effet, le panneau solaire proposé se compose du module photovoltaïque et d'un échangeur thermique placé en vis-à-vis de la face arrière dudit module. Au moins la face supérieure de l'échangeur est fabriquée en matière plastique diminuant ainsi les coûts ainsi que le poids du panneau. L'échangeur proposé comporte une zone d'échange thermique disposée sous le module photovoltaïque et dans laquelle s'écoule un fluide de refroidissement. Ce fluide se déplace dans des canaux internes s'étendant depuis une zone d'arrivée du fluide jusqu'à une zone d'évacuation.

Le panneau solaire décrit dans le document brevet EP 2.284.910 (ROTH WERKE GMBH) propose un échangeur se composant d'une face inférieure et d'une face supérieure distinctes l'une de l'autre. Dans une telle configuration, il est nécessaire d'avoir au moins une des faces qui soit conformée de manière à pouvoir former les canaux internes lors de la fabrication de l'échangeur. Une telle conception nécessite d'avoir des parois relativement épaisses (généralement supérieures à 1.5 mm). De telles épaisseurs réduisent l'échange thermique entre l'échangeur et le fluide de refroidissement, rendant le rendement du panneau solaire médiocre. En outre, la conception d'un tel panneau est complexe et demande un temps et un coût de fabrication considérables.

De plus, dans certaines installations, un effet de thermosiphon est souhaité. Celui-ci correspond au phénomène de circulation naturelle d'un liquide due à son changement de masse en fonction du gradient de température. La configuration de l'échangeur divulgué dans le brevet EP 2.284.910 est susceptible de perturber cet effet thermosiphon, rendant par conséquent, le rendement énergétique du panneau médiocre.

De plus, avec le type de panneau solaire décrit dans le document brevet EP 2.284.910, une déformation des canaux peut être observée sous pression. Cette déformation va entraîner une déformation de l'échangeur, et par conséquent celui-ci n'est pas correctement plaqué contre la face arrière du module photovoltaïque, ce qui contribue à limiter les échanges thermiques et donc réduit le rendement énergétique du panneau solaire.

Le document brevet WO 2008/003109 (BIERBAUMER HANS-PETER) divulgue un panneau solaire dans lequel la zone d'échange thermique est formée par une plaque alvéolaire double paroi, laquelle plaque alvéolaire se compose d'une paroi supérieure et d'une paroi inférieure s'étendant entre deux extrémités latérales de ladite plaque et entre lesquelles sont agencées des alvéoles, lesquelles alvéoles se présentent sous la forme de canaux internes adjacents. Bien que les zones d'arrivée et d'évacuation du fluide ne soient pas décrites, il apparaît en pratique que les pertes de charge dans les canaux sont importantes et que la circulation du fluide dans lesdits canaux n'est pas homogène. En outre, la conception de ce type de canaux est relativement complexe.

L'invention vise à remédier à cet état des choses. En particulier, un objectif de l'invention est de simplifier la conception des échangeurs pour panneaux solaires hybrides de façon à diminuer les coûts.

Un autre objectif de l'invention est de diminuer les pertes de charge dans les canaux et d'améliorer l'homogénéité de la circulation du fluide.

Un objectif supplémentaire de l'invention est d'alléger la structure du panneau solaire.

Un autre objectif de l'invention est d'améliorer les échanges thermiques entre le module photovoltaïque et l'échangeur thermique.

Encore un autre objectif de l'invention est de proposer un échangeur dont la configuration permet d'obtenir un rendement énergétique optimisé.

Un autre objectif de l'invention est de proposer un échangeur qui permette de conserver et/ou de favoriser l'effet thermosiphon.

### Divulgation de l'invention.

La solution proposée par l'invention est un panneau solaire hybride selon la revendication 1 et une méthode selon la revendication 15.

Le panneau comprends:
- un module photovoltaïque comportant une face avant et une face arrière,
- un échangeur thermique disposé en vis-à-vis de la face arrière dudit module photovoltaïques,
- un fluide de refroidissement circulant dans ledit échangeur thermique de manière à récupérer les calories dudit module photovoltaïque,
- ledit échangeur thermique comportant une zone d'échange thermique disposée sous ledit module photovoltaïque et dans laquelle s'écoule le fluide de refroidissement, lequel fluide s'écoule entre une zone d'arrivée et une zone d'évacuation,
- des canaux internes s'étendant sur toute la surface de la zone d'échange,
- la zone d'échange thermique est formée par une plaque alvéolaire double paroi, laquelle plaque alvéolaire se compose d'une paroi supérieure et d'une paroi inférieure s'étendant entre deux extrémités latérales de ladite plaque et entre lesquelles sont agencées des alvéoles, lesquelles alvéoles se présentent sous la forme de canaux adjacents, qui sont en communication fluidique avec les zones d'arrivée et d'évacuation.

Cette invention est remarquable en ce que :
- les extrémités latérales sont bouchées,
- la plaque alvéolaire comporte des ouvertures aménagées dans la paroi inférieure pour mettre en communication fluidique chaque canal respectivement avec la zone d'arrivée et la zone d'évacuation,
- les zones d'arrivée et d'évacuation se présentent sous la forme de collecteurs placés sur la paroi inférieure de ladite plaque alvéolaire au niveau des ouvertures, de sorte que la paroi supérieure de cette dernière reste plane sur toute sa surface.

L'utilisation d'une telle plaque alvéolaire permet d'obtenir un échangeur très léger et donc facilement manipulable. Entre autres, cette plaque alvéolaire, en plus de diminuer le prix de revient du panneau solaire hybride, permet d'améliorer le rendement énergétique. En effet, ce type de plaque alvéolaire a généralement des parois très fines qui favorisent les échanges thermiques avec le module photovoltaïque auquel elle est associée. De plus, la présence de canaux internes adjacents permet de faire circuler un fluide sous une pression pouvant aller jusqu'à 7 bars (0.7 MPa), les déformations de l'échangeur étant nulles ou à tout le moins négligeables (inférieures à 0.25 mm sous 3 bars (0.3 MPa)), améliorant ainsi les performances du panneau solaire hybride. L'aménagement des ouvertures permet de simplifier la conception de l'échangeur. La mise en place des collecteurs au niveau de ces ouvertures permet de diminuer les pertes de charge dans les canaux et d'avoir une circulation homogène du fluide dans chacun desdits canaux.

D'autres caractéristiques avantageuses de l'invention sont listées ci-dessous. Chacune de ces caractéristiques peut être considérée seule ou en combinaison avec les caractéristiques remarquables définies ci-dessus, et faire l'objet, le cas échéant, d'une ou plusieurs demandes de brevets divisionnaires :
- la plaque alvéolaire est préférentiellement délimitée par les deux extrémités latérales bouchées et deux bords longitudinaux ; chacune des ouvertures ayant une forme rectangulaire qui s'étend dans la largeur de la plaque alvéolaire parallèlement aux extrémités latérales bouchées et perpendiculairement aux bords longitudinaux de ladite plaque,
- la totalité de la paroi supérieure de la plaque alvéolaire peut être plane,
- l'échangeur thermique peut être en polypropylène,
- les collecteurs peuvent être soudés à la plaque alvéolaire au niveau d'une des ouvertures,
- chaque collecteur peut se présenter sous la forme d'un caisson parallélépipédique étanche qui s'étend dans la largeur de la plaque alvéolaire,
- chaque collecteur peut être équipé d'un connecteur non-coudé orienté vers l'extérieur du panneau, lesdits connecteurs étant décalés l'un par rapport à l'autre,
- les canaux internes peuvent avoir une largeur comprise entre 4 mm et 6 mm et une hauteur comprise entre 4 mm et 6 mm,
- la profondeur des collecteurs peut être supérieure à la hauteur des canaux internes,
- le panneau solaire hybride peut être constitué par l'empilement successif des éléments suivants, agencés de la face avant du module photovoltaïque vers la paroi inférieure de l'échangeur :
   ∘ une couche ou plaque d'un matériau transparent définissant la face avant du module photovoltaïque,
   ∘ une première couche d'un matériau encapsulant en contact intime avec la couche ou plaque de matériau transparent,
   ∘ au moins un élément photovoltaïque en contact intime avec la première couche de matériau encapsulant,
   ∘ une seconde couche d'un matériau encapsulant en contact intime avec au moins un élément photovoltaïque,
   ∘ la plaque alvéolaire en contact intime avec la seconde couche de matériau encapsulant,
   ∘ une couche ou plaque d'un matériau isolant en contact intime avec ladite plaque alvéolaire.
- la paroi supérieure de la plaque alvéolaire peut avoir une épaisseur inférieure à 1 mm,
- une plaque isolante supplémentaire peut être placée contre la paroi inférieure de la plaque alvéolaire,
- la plaque isolante supplémentaire peut être une plaque en nid d'abeille,
- l'échangeur thermique et le module photovoltaïque peuvent être maintenus en place par un cadre, ledit cadre comprenant des moyens de pression pour que la plaque isolante supplémentaire soit contrainte contre la paroi inférieure de la plaque alvéolaire de sorte que toute la surface de la paroi supérieure de cette dernière soit plaquée contre la face arrière du module photovoltaïque,
- une couche de gel peut être placée entre la zone d'échange thermique et le module photovoltaïque.

L'invention concerne aussi un procédé de fabrication du panneau solaire hybride selon l'invention comprenant les étapes consistant à :
- utiliser une plaque alvéolaire dont les canaux débouchent latéralement au niveau des extrémités de ladite plaque,
- boucher les extrémités latérales de la plaque alvéolaire de manière à obturer les canaux internes,
- aménager une ouverture au niveau de chaque extrémité latérale de la paroi inférieure de la plaque de sorte que chaque dite ouverture débouche dans chacun des canaux,
- plaquer la paroi supérieure de la plaque alvéolaire contre la face arrière du module photovoltaïque,
- maintenir en position la plaque alvéolaire contre le module photovoltaïque,
- installer un collecteur au niveau de chacune des ouvertures, lesquels collecteurs forment respectivement une zone d'arrivée et une zone d'évacuation,
- connecter les collecteurs à un circuit d'alimentation en fluide de refroidissement de sorte que le fluide s'écoule depuis la zone d'arrivée jusqu'à la zone d'évacuation.

Le procédé peut aussi contenir une étape consistant à maintenir la plaque alvéolaire en position contre le module photovoltaïque au moyen d'une cadre, ledit cadre comprenant des moyens de pression pour que la plaque isolante supplémentaire soit contrainte contre la paroi inférieure de la plaque alvéolaire de sorte que toute la surface de la paroi supérieure de cette dernière soit plaquée contre la face arrière du module photovoltaïque.

### Description des figures.

D'autres avantages et caractéristiques de l'invention apparaîtront mieux à la lecture de la description d'un mode de réalisation préféré qui va suivre, en référence aux dessins annexés, réalisés à titre d'exemples indicatifs et non limitatifs et sur lesquels :
- la figure 1 est une représentation schématique en coupe d'un panneau solaire hybride conforme à l'invention,
- la figure 2 est une représentation schématique en coupe d'un panneau solaire hybride conforme à l'invention, dans une variante de réalisation comportant une couche de gel entre le module photovoltaïque et l'échangeur de chaleur,
- la figure 3 est une vue en coupe selon A-A du panneau selon l'une des figures 1 ou 2,
- la figure 4 est une vue schématique en perspective, d'une plaque alvéolaire utilisée dans l'invention,
- la figure 5a est une vue en coupe selon B-B de la plaque alvéolaire de la figure 4,
- la figure 5b montre la plaque de la figure 5a, sur laquelle la paroi inférieure a été retirée,
- la figure 5c montre la plaque de la figure 5b, associée à un collecteur,
- la figure 5d montre l'ensemble de la figure 5c, le collecteur étant installé contre la plaque alvéolaire,
- la figure 6a montre schématiquement un module photovoltaïque associé à un échangeur conforme à l'invention,
- la figure 6b montre le module photovoltaïque et l'échangeur de la figure 6a associés à une plaque isolante,
- la figure 6c montre l'ensemble de la figure 6b maintenu en position par un cadre, de manière à former un panneau solaire hybride conforme à l'invention,
- la figure 7 est une représentation schématique en coupe des différentes couches formant le module photovoltaïque,
- la figure 8 est une vue schématique de dessous d'une plaque alvéolaire conforme à l'invention, les canaux étant bouchés et les ouvertures découpées,
- la figure 9a est une vue schématique de dessous en perspective d'un panneau solaire hybride conforme à l'invention,
- les figures 9b et 9c sont des vues schématiques de dessous en perspective, de variantes du panneau de la figure 9a.

### Modes préférés de réalisation de l'invention.

Le panneau solaire **P** objet de l'invention est un panneau hybride, c'est-à-dire qu'il est capable de produire simultanément une énergie électrique et une énergie thermique. Il est destiné à être utilisé seul ou en combinaison avec d'autres panneaux similaires, de façon à ce que l'énergie électrique et thermique qu'il produit soient exploitables par une habitation ou une installation.

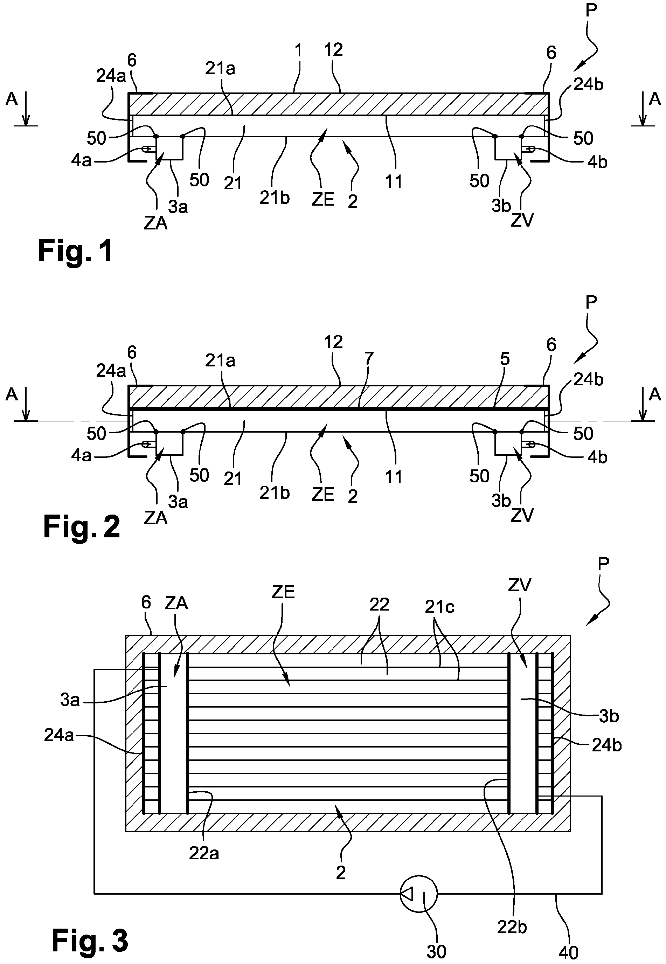

En se rapportant aux figures 1 et 2, le panneau solaire **P** comporte un module photovoltaïque **1** présentant une face avant **12** et une face arrière **11**. La face avant **12** est laissée libre de façon à ce qu'elle puisse recevoir le rayonnement solaire. Environ 80% de l'énergie solaire reçue est dissipée dans le panneau **P**. La présence d'un échangeur thermique **2** placé en vis-à-vis de la face arrière **11** du module photovoltaïque **1** permet de récupérer la chaleur accumulée ou dissipée dans le module photovoltaïque **1.**

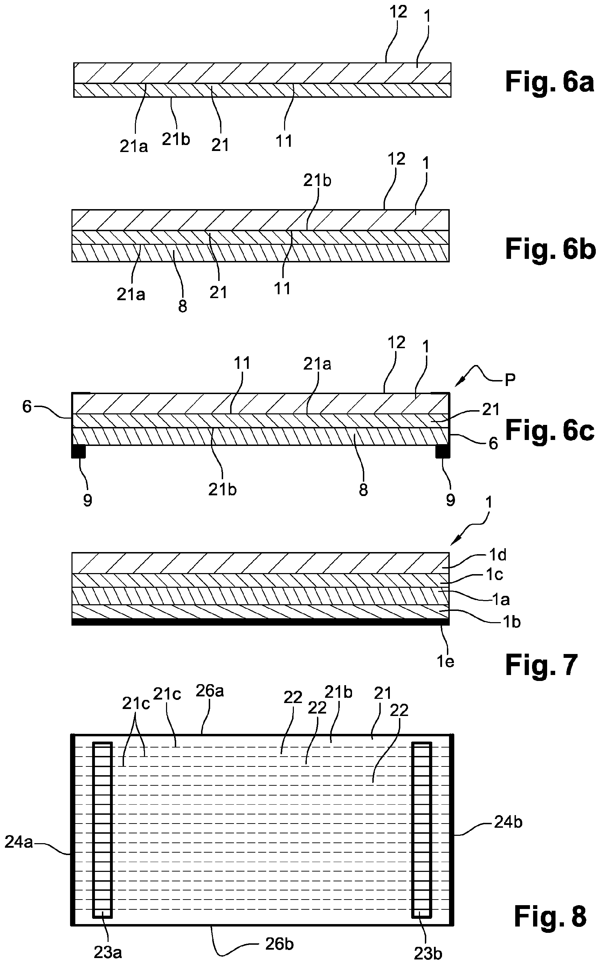

Sur la figure 7, le module photovoltaïque **1** comporte au moins un, et avantageusement plusieurs éléments photovoltaïques **1a** placés dans un le même plan. Ces derniers sont reliés électriquement entre eux, en série ou en parallèle, et sont encapsulés, par exemple dans un polymère thermoplastique **1b, 1c** tel que l'éthylène acétate de vinyle (EVA) ou encore le silicone pour former le module photovoltaïque **1.** La face avant **12** du module photovoltaïque **1** exposée au rayonnement est recouverte d'une plaque transparente **1d,** comme par exemple une plaque de verre.

Une couche **1e** de matériau isolant électrique appelée « backsheet » est ajoutée sur la face arrière **11** du module photovoltaïque **1.** Cette couche **1e** assure, en plus de l'isolation électrique, une fonction d'étanchéité entre le module photovoltaïque **1** et l'échangeur thermique **2.** Cette couche **1e** peut, par exemple, être un film de fluorure de polyvinyle, et permet d'empêcher la pluie et/ou l'humidité de l'air ambiant d'entrer en contact direct avec le module photovoltaïque **1**, évitant ainsi tout problème électrique, comme par exemple des faux contacts ou des courts circuits.

Il est toutefois possible de supprimer la couche **1e** de matériau isolant électrique. Dans ce cas particulier la face arrière **11** est constituée par la couche d'encapsulation **1b**. , La fonction d'étanchéité et d'isolant électrique est alors reprise par l'échangeur thermique **2,** qui couvre alors toute la surface du module photovoltaïque **1.**

Ces différents éléments **1a, 1b, 1c, 1d, 1e** sont empilés sous forme de sandwich et sont maintenus ensemble par un procédé de laminage à chaud.

L'échangeur **2** est situé sous le module photovoltaïque **1** de manière à ne pas faire obstacle au rayonnement solaire. Dans le mode de réalisation représenté sur la figure 2, une couche **7** de matériau pâteux et/ou malléable, est insérée entre la face arrière **11** du module photovoltaïque **1** et la face supérieure **21a** de l'échangeur thermique **2**. L'utilisation d'un matériau **7** pâteux et/ou malléable permet de maintenir permet de maintenir le module photovoltaïque **1** et l'échangeur thermique **2** en contact malgré les déformations éventuelles de ce dernier, tout en évitant la présence d'air entre ces deux éléments. L'épaisseur de la couche **7** peut varier de 0,1 mm à 1 cm, de préférence inférieur à 1 mm, de manière à avoir une fine couche **7** permettant de laisser passer la chaleur malgré le fait d'utiliser un matériau isolant thermique. Le matériau utilisé est préférentiellement un gel, mais peut aussi se présenter sous la forme d'un matériau viscoélastique, d'une colle, d'un polymère, ou encore toute autre forme convenant à l'Homme du métier.

En se rapportant à la figure 3, l'échangeur **2** comporte trois zones principales : une zone d'arrivée **ZA** du fluide de refroidissement, une zone d'échange thermique **ZE** et une zone d'évacuation **ZV** dudit fluide. Le module photovoltaïque **1** est préférentiellement positionné en vis-à-vis de la zone d'échange **ZE** mais peut aussi se trouver au moins partiellement au dessus des zones d'arrivée **ZA** et d'évacuation **ZV.** La zone d'échange **ZE** peut par exemple représenter de 10% à 100% de la surface du module photovoltaïque **1**.

L'échangeur thermique **2** est en matériau plastique, préférentiellement en polypropylène, mais il peut être en polyéthylène, en polyméthacrylate de méthyle, en polysulfure de phénylène, en polyphénylène oxyde, en polyphénylène éther, acrylonitrile butadiène styrène, ou encore toute autre matière convenant à l'Homme du métier. Ces matériaux permettent de résister de manière pérenne à la corrosion générée par le fluide de refroidissement, ainsi qu'à des températures pouvant aller jusqu'à 90°C. L'échangeur **2** peut aussi se composer d'un polymère chargé, comme par exemple avec des fibres de verres, permettant ainsi d'améliorer sa rigidité.

Le fluide de refroidissement, qui est typiquement de l'eau glycolée, circule dans l'échangeur thermique **2** afin de récupérer les calories issues du module photovoltaïque **1**. Il est acheminé par l'intermédiaire d'un circuit d'alimentation **40** et circule toujours dans le même sens dans l'échangeur **2,** depuis la zone d'arrivée **ZA** jusqu'à la zone d'évacuation **ZV** en passant par la zone d'échange thermique **ZE.**

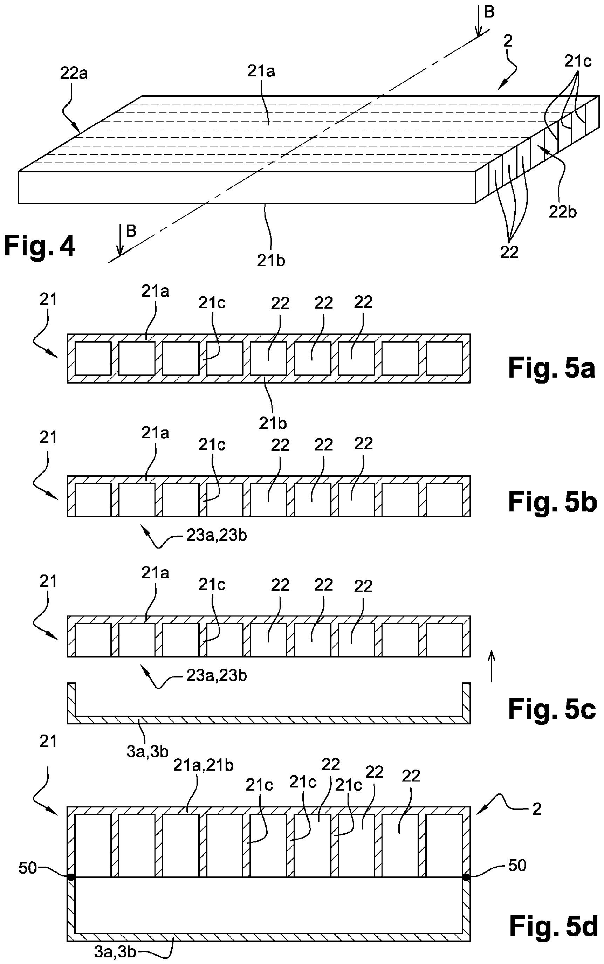

L'échangeur **2** est composé d'une plaque alvéolaire **21** et de collecteurs **3a, 3b**. Les collecteurs **3a, 3b** forment respectivement les zones d'arrivée **ZA** et d'évacuation **ZV**, alors que la zone d'échange **ZE** est constituée par la plaque alvéolaire **21.** Sur les figures 4 et 5a, celle-ci est composée d'une paroi supérieure **21a** plane destinée à être en contact avec la face arrière **11** du module photovoltaïque **1** et d'une paroi inférieure **21b.** Les parois supérieure **21a** et inférieure **21b** sont préférentiellement planes et parallèles entre elles. La surface de la plaque 21 représente par exemple entre 10% à 100% de la surface totale du module photovoltaïque 1. Elle a préférentiellement des dimensions (longueur et largeur) correspondant à celles du module photovoltaïque **1**, tous deux étant de forme générale rectangulaire. Elle a une longueur pouvant être comprise entre 150 cm et 400 cm, une largeur variant de 50 cm à 300 cm, et une épaisseur variant de 1 mm à 2 cm. Elle peut par exemple être fabriquée par la société DS Smith sous les marques Akysun®, Akylux®, Akyplac® ou encore Correx®, et obtenue par un procédé d'extrusion ou par moulage.

Sur les figures 4 et 5a, des alvéoles en forme de canaux **22** sont disposées entre la paroi supérieure **21a** et la paroi inférieure **21b**. Les canaux **22** ont une section carrée, rectangulaire, circulaire ou ovale, trapézoïdale. Ils sont préférentiellement rectilignes. Les canaux internes **22** sont délimités par des parois internes de séparation **21c** qui sont perpendiculaires ou sensiblement perpendiculaires aux parois supérieure **21a** et inférieure **21b**, de sorte que lesdits canaux **22** soient adjacents. Deux canaux internes **22** adjacents côte à côte ont ainsi une paroi de séparation **21c** en commun. Ils sont préférentiellement parallèles les uns par rapport aux autres mais peuvent aussi être non parallèles.

Ces parois **21a** et **21b** ont une épaisseur comprise entre 0.4 mm et 10 mm, avantageusement entre 0.4 mm et 1.2 mm, préférentiellement 0.8 mm. Cette faible épaisseur permet d'obtenir un bon transfert de chaleur entre le module photovoltaïque **1** et le fluide de refroidissement qui circule dans les canaux **22**. Les parois internes **21c** ont une hauteur pouvant varier de 1 mm à 2 cm, et une épaisseur comprise entre 0.4 mm et 1.2 mm. La hauteur des canaux internes **22** dépend donc de l'épaisseur de la plaque **21** ainsi que de la hauteur des parois internes de séparation **21c**. Elle est comprise entre 1 mm et 2 cm, préférentiellement 5 mm.

La largeur des canaux internes **22** varie de 1 mm à 20 mm, avantageusement entre 1 mm et 10 mm, préférentiellement 5 mm. Leur hauteur varie entre 1 mm et 20 mm, préférentiellement 5 mm. La largeur des canaux **22** est choisie de manière à obtenir des pertes de charge négligeables et favoriser l'effet thermosiphon lors de la circulation du fluide de refroidissement entre la zone d'arrivée ZA et la zone d'évacuation ZV. La demanderesse s'est aperçu de manière surprenante que des canaux internes **22** ayant une section carrée d'environ 5 mm de côte, permettaient de conserver un bon effet thermosiphon entre la zone d'arrivée **ZA** et la zone d'évacuation **ZV**.

L'utilisation d'une plaque alvéolaire **21** ayant des canaux internes **22** de dimensions telles que celles décrites dans le paragraphe précédent, permet de réduire le volume, et donc le poids du fluide circulant dans le panneau solaire hybride **P**. De plus les canaux **22** adjacents présents dans la plaque **21** permettent de résister à des pressions pouvant aller jusqu'à 7 bars (0.7 MPa). Les effets de la pression du fluide dans les canaux **22** s'annulent. La paroi supérieure **21a** de la plaque **21** peut éventuellement se déformer, ces déformations étant toutefois limitées, voire absentes, du fait des dimensions réduites des canaux **22**.

Le matériau plastique dans lequel est formée la plaque alvéolaire **21** n'étant pas naturellement un bon conducteur de chaleur, la parois **21a** a préférentiellement une épaisseur minimale pour ne pas freiner le passage de la chaleur entre le module photovoltaïque **1** et le fluide de refroidissement circulant dans la zone d'échange thermique **ZE**. Toutefois, cette épaisseur doit être assez importante pour résister au vieillissement ainsi qu'aux contraintes de pression de l'échangeur thermique **2** et ainsi éviter toute rupture éventuelle. La paroi **21a** ayant une épaisseur d'environ 0.8 mm donne de très bons résultats. La paroi inférieure **21b** peut avoir une épaisseur supérieure à celle de la paroi **21a**, permettant ainsi d'améliorer la rigidité du panneau **P**.

Les canaux **22** permettent au fluide de refroidissement de s'écouler de la zone d'arrivée **ZA** à la zone d'évacuation **ZV**. En se rapportant à la figure 3, ils possèdent chacun une entrée **22a** débouchant dans la zone d'arrivée **ZA** et une sortie **22b** débouchant dans la zone d'évacuation **ZV**. Les entrée **22a** et sortie **22b** peuvent se situer au niveau des extrémités latérales de la plaque alvéolaire **21**, mais elles peuvent aussi être décalées de ces extrémités latérales vers le centre de ladite plaque.

Les collecteurs **3a**, **3b** et la plaque alvéolaire **21** sont préférentiellement des pièces distinctes. Sur les figures annexées, chaque collecteur **3a**, **3b** se présente sous la forme d'un caisson parallélépipédique étanche qui s'étend dans la largeur de la plaque alvéolaire **21**, préférentiellement à chacune de ses extrémités latérales **24a, 24b,** et de manière plus générale au niveau de chacune des ouvertures **23a, 23b**. La longueur des collecteurs **3a, 3b** est, de préférence, sensiblement similaire à la largeur de la plaque alvéolaire **21** et peut donc être comprise entre 50 cm et 300 cm. Leur largeur peut varier de 5 cm à 50 cm et leur hauteur de 1 mm à 2 cm. Préférentiellement, la hauteur des collecteurs **3a, 3b** est supérieure à celle des canaux internes **22** de sorte que leur perte de charge est inférieure à celle des canaux **22.** Ainsi lorsque le fluide de refroidissement arrive dans la zone d'arrivée **ZA**, il va d'abord remplir cette dernière avant de pénétrer dans les canaux **22.** De même, le fluide va pouvoir s'évacuer sans contrainte dans la zone d'évacuation **ZV.** Le fluide va ainsi circuler dans les canaux **22**, de manière homogène, sans circuit préférentiel et dans la totalité de la zone d'échange thermique **ZE.**

Les collecteurs **3a, 3b** sont formés par thermoformage, injection, ou encore extrusion. Ils sont ensuite soudés préférentiellement sur la paroi inférieure **21b** de la plaque alvéolaire **21** (figure 4a) de manière à faciliter l'installation ainsi que le transport du panneau solaire **P**. Cette position permet un empilement optimal des panneaux **P** et donc un gain de place considérable lors de leur transport. Cependant, ils peuvent être installés à chacune des extrémités de la plaque **21**, sur la face avant de la plaque **21**, ou encore n'importe quelle position convenant à l'Homme du métier.

Comme cela apparaît sur la figure 4, les canaux **22** débouchent initialement au niveau des extrémités latérales **24a, 24b** de la plaque alvéolaire **21**. Pour former l'échangeur thermique **2**, ces extrémités **24a, 24b** sont préalablement bouchées par un procédé de fusion-pressage vers l'intérieur de la plaque **21**, ou par apport de matière et collage et/ou soudage, ou par laser, ou par ultrasons, ou par vibration, ou encore par soudage à chaud (miroir, lame chaude, infrarouge).

Les figures 5a à 5d illustrent les étapes permettant d'aboutir à la mise en place des collecteurs **3a, 3b** contre la plaque alvéolaire **21.** Comme le montrent les figures 8 et 5b, des ouvertures **23a, 23b** sont préalablement réalisées dans la paroi inférieure **21b** de la plaque alvéolaire **21.** Elles sont créées en retirant par découpe, des parties de la paroi inférieure **21b.** Ces ouvertures **23a, 23b** sont situées au niveau des extrémités bouchées **24a, 24b,** et peuvent être légèrement décalées de ces dernières de quelques millimètres. Chacune des ouvertures **23a**, **23b** a une forme rectangulaire qui s'étend dans la largeur de la plaque **21**, parallèlement aux extrémités latérales **24a, 24b** et perpendiculairement aux bords longitudinaux **26a, 26b** de ladite plaque. Elles sont préférentiellement effectuées sur toute la largeur de la plaque **21**, mais peuvent être positionnées dans n'importe quelle autre position dès lors qu'elles débouchent dans chacun des canaux internes **22.** Elles ont une longueur comprise entre 30 cm et 300 cm, et une largeur variant de 1 cm à 10 cm.

Une fois ces ouvertures **23a, 23b** réalisées, les collecteurs **3a, 3b** peuvent être rapportés (figure 5c). Ils sont placés contre la paroi inférieure **21b** de la plaque alvéolaire **21**, en vis-à-vis des ouvertures **23a, 23b**, de manière à être en communication fluidique avec chacun des canaux **22.** Ainsi positionnés contre la paroi inférieure **21b**, les collecteurs **3a, 3b** laissent la paroi supérieure **21a** de la plaque **21**, totalement plane. De fait, toute la surface de la paroi supérieure **21a** est susceptible d'être en contact avec la face arrière **11** du module photovoltaïque **1**, ce qui permet de maximiser la surface d'échange thermique. Ils sont ensuite soudés contre la paroi inférieure **21b** de la plaque alvéolaire **21.** La soudure **50** (figure 5d) peut être effectuée de différentes manières, comme par exemple par apport de matière, par soudage laser, soudage par ultrasons, soudage par lame chauffante ou infrarouges, ou encore soudage par vibration. Le soudage est préférentiellement effectué par apport de matière pour renforcer les zones de soudage qui sont des zones de sollicitation mécanique lorsque le panneau solaire **P** est utilisé sous pression. Le soudage est le choix préférentiel, mais en fonction du polymère utilisé, les collecteurs **3a, 3b**, peuvent aussi être collés ou vissés contre la plaque alvéolaire **21.**

Sur les figures 1, 2 et 3, les collecteurs **3a, 3b** sont pourvus de moyens de connexion **4a, 4b** permettant de connecter l'échangeur thermique **2** à un circuit d'alimentation **40** en fluide de refroidissement. Ces moyens de connexion **4a, 4b** peuvent être des connecteurs mais peuvent aussi se présenter sous n'importe quelle autre forme convenant à l'Homme du métier. Suivant les dimensions des collecteurs **3a, 3b** utilisés, ils peuvent avoir un diamètre interne variant de 8 mm à 30 mm. Dans ce circuit **40,** le fluide circule naturellement de la zone d'évacuation **ZV** vers la zone d'arrivée **ZA** grâce à l'effet thermosiphon. Toutefois, ce circuit **40** peut comporter une pompe **30** assurant la mise en circulation du fluide de refroidissement. La pompe d'alimentation **30** peut être, par exemple une pompe à piston ou encore une pompe à membrane.

Chaque moyen de connexion **4a, 4b** peut être réalisé dans la même pièce que le collecteur **3a, 3b**, et ainsi former une pièce monobloc qui permet de diminuer les fuites éventuelles de fluide de refroidissement. Ils peuvent toutefois être des pièces distinctes qui sont installées ultérieurement sur les collecteurs **3a**, **3b** grâce à des moyens de fixation tels qu'une soudure, ou par collage, ou encore par vissage.

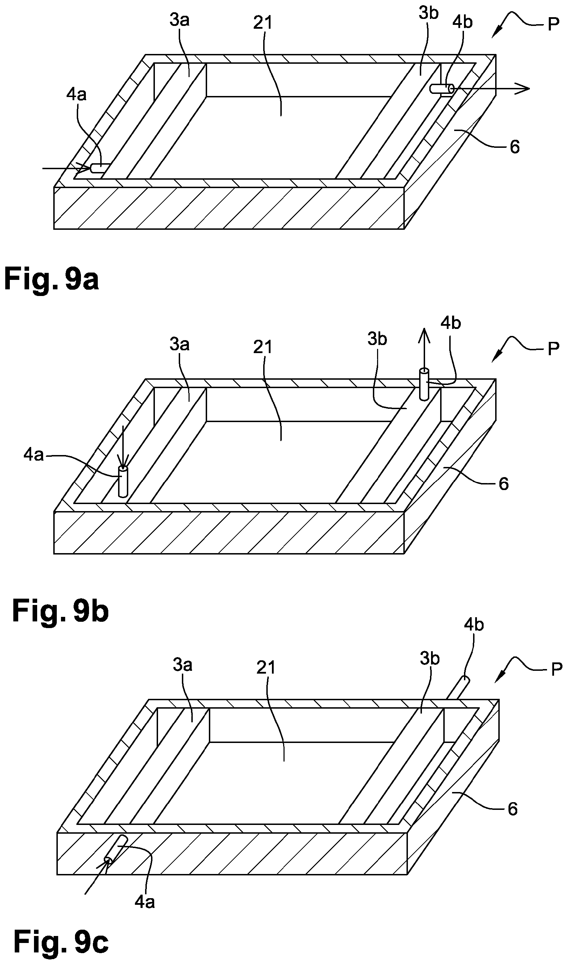

Les moyens de connexion **4a, 4b** sont préalablement installés pour ne pas générer de contre-pente susceptible de perturber l'effet thermosiphon décrit précédemment. Ainsi, ils sont préférentiellement positionnés de manière à ce que la direction d'écoulement du fluide de refroidissement aille du bas de l'échangeur thermique **2** vers le haut. Les moyens de connexion **4a, 4b** sont avantageusement disposés dans le plan de la plaque alvéolaire **21** (figure 9a, figure 9c). Toutefois, ils peuvent aussi être disposés perpendiculairement à la plaque **21** (figure 9b). De la même manière, ces moyens de connexion **4a, 4b** sont préférentiellement installés de manière à ne pas dépasser du cadre **6** (figure 9a), ils peuvent toutefois déborder du cadre **6** (figure 9c).

Les moyens de connexion **4a, 4b** sont préférentiellement disposés en diagonale l'un par rapport à l'autre de manière à uniformiser le trajet du fluide depuis la zone d'arrivée **ZA** jusqu'à la zone d'évacuation **ZV.** Toutefois, ils peuvent être placés dans n'importe quelle position convenant à l'Homme du métier.

Les figures 6a à 6d montrent différentes étapes d'un procédé de fabrication du panneau solaire **P.** La figure 6a montre la mise en place de l'échangeur thermique **2** contre la face arrière **11** du module photovoltaïque **1.** Sur la figure 6b, une plaque supplémentaire **8** est installée contre la paroi inférieure **21b** de la plaque alvéolaire **21.**

La plaque **8** peut être une couche de plastique tel que le polypropylène, le polystyrène, le polyuréthane, ou encore le polyéthylène. Elle peut aussi se présenter sous la forme d'un panneau rigide en nid d'abeille. La plaque **8** est présente sur toute la surface correspondant à la zone d'échange (ZE) de l'échangeur thermique **2** avec une longueur comprise entre 150 cm et 400 cm, une largeur variant de 50 cm à 300 cm. Son épaisseur est comprise entre 2 mm et 5 cm suivant le type de matériau utilisé.

En plus de sa fonction d'isolant, la plaque supplémentaire **8,** lorsqu'elle est rigide, permet de maintenir l'échangeur thermique **2** en place dans le cas où le panneau **P** comporte un cadre **6.** Ce cadre **6** est préférentiellement en aluminium ou en polymère, et est formé de profilés en U assemblés entre eux par soudage ou par vissage. Comme illustré sur la figure 6c, le cadre **6** comprend avantageusement, des moyens de pression **9** permettant de contraindre la plaque **8** contre la paroi inférieure **21b** de la plaque alvéolaire **21.** Ces moyens de pression **9** peuvent se présenter sous différentes formes, comme par exemple, des calles ajoutées au cadre **6,** des calles intégrées au cadre **6,** ou encore des équerres.

Grâce à la plaque **8** et aux moyens de pression **9,** la paroi supérieure **21a** de la plaque alvéolaire **21** est plaquée de la manière la plus uniforme possible contre la face arrière **11** du module photovoltaïque **1**, ce qui assure un échange thermique optimal. De préférence, l'ensemble constitué de l'échangeur thermique **2** et de la plaque **8,** ne dépasse pas du cadre **6** de manière à faciliter le transport et l'installation du panneau photovoltaïque.

L'agencement des différents éléments et/ou moyens et/ou étapes de l'invention, dans les modes de réalisation décrits ci-dessus, ne doit pas être compris comme exigeant un tel agencement dans toutes les implémentations. En tout état de cause, on comprendra que diverses modifications peuvent être apportées à ces éléments et/ou moyens et/ou étapes, sans s'écarter de l'esprit et de la portée de l'invention. En particulier :
- Il peut y avoir ou non une couche **7** entre le module photovoltaïque **1** et l'échangeur thermique **2,**
- la paroi inférieure **21b** n'est pas forcément identique à la paroi supérieure **21a,**
- la paroi inférieure **21b** peut avoir une épaisseur supérieure à 1 mm,
- le panneau solaire hybride **P** peut ou non comporter une plaque supplémentaire **8,** dans ce cas les moyens de pression **9** sont directement en appui sur la plaque alvéolaire **21**,
- les collecteurs **3a, 3b** peuvent être légèrement insérés dans les ouvertures **23a, 23b** avant d'effectuer la soudure **50**,
- les moyens de pression **9** peuvent être différents de ceux mentionnés précédemment. Ils peuvent par exemple, se présenter sous la forme de barres reliant les bords longitudinaux **26a, 26b** de la plaque **21**,
- dans le module photovoltaïque **1**, le verre **1d** peut être remplacé par un matériau appelé « frontsheet », transparent, souple, résistant aux ultraviolets, à base, par exemple, de fluoropolymère tel que le tétrafluoroéthylène ou ETFE,
- les couches **1b, 1c** de matériau encapsulant ne sont pas forcément les mêmes.

## Revendications

1. Panneau solaire hybride (P) comprenant :
- un module photovoltaïque (1) comportant une face avant (12) et une face arrière (11),
- un échangeur thermique (2) disposé en vis-à-vis de la face arrière (11) dudit module photovoltaïque (1),
- un fluide de refroidissement circulant dans ledit échangeur thermique (2) de manière à récupérer les calories dudit module photovoltaïque (1),
- l'échangeur thermique (2) comportant une zone d'échange thermique (ZE) disposée sous ledit module photovoltaïque (1) et dans laquelle s'écoule le fluide de refroidissement, lequel fluide s'écoule entre une zone d'arrivée (ZA) et une zone d'évacuation (ZV),
- des canaux internes (22) s'étendant sur toute la surface de la zone d'échange (ZE),
- la zone d'échange thermique (ZE) est formée par une plaque alvéolaire (21) double paroi, laquelle plaque alvéolaire (21) se compose d'une paroi supérieure (21a) et d'une paroi inférieure (21b) s'étendant entre deux extrémités latérales (24a, 24b) de ladite plaque (21) et entre lesquelles sont agencées des alvéoles, lesquelles alvéoles se présentent sous la forme de canaux internes (22) adjacents, qui sont en communication fluidique avec les zones d'arrivée (ZA) et d'évacuation (ZV),
**se caractérisant par le fait que :**
- les extrémités latérales (24a, 24b) sont bouchées, lesdites extrémités latérales (24a, 24b) et deux bords longitudinaux (26a, 26b) délimitant la plaque alvéolaire (21),
- la plaque alvéolaire (21) comporte une première ouverture (23a) aménagée dans la paroi inférieure (21b) et qui débouche dans chacun des canaux internes (22) pour mettre en communication fluidique chaque canal (22) avec la zone d'arrivée (ZA) et une seconde ouverture (23b) aménagée dans ladite paroi inférieure (21b) et qui débouche dans chacun des canaux internes (22) pour mettre en communication fluidique chaque canal (22) avec la zone d'évacuation (ZV),
- chacune des ouvertures (23a, 23b) a une forme rectangulaire qui s'étend dans la largeur de la plaque alvéolaire (21) parallèlement aux extrémités latérales bouchées (24a, 24b) et perpendiculairement aux bords longitudinaux (26a, 26b) de ladite plaque (21),
- les zones d'arrivée (ZA) et d'évacuation (ZV) se présentent sous la forme de collecteurs (3a, 3b) placés sur la paroi inférieure (21b) de ladite plaque alvéolaire (21) au niveau des ouvertures (23a, 23b), de sorte que la paroi supérieure (21a) de cette dernière reste plane sur toute sa surface.

2. Panneau solaire hybride (P) selon la revendication 1, **caractérisé en ce que** l'échangeur thermique est en polypropylène.

3. Panneau solaire hybride (P) selon l'une des revendications 1 ou 2, **caractérisé en ce que** chaque collecteur (3a, 3b) est soudé à la plaque alvéolaire (21) au niveau d'une des ouvertures (23a, 23b).

4. Panneau solaire hybride (P) selon l'une des revendications 1 à 3, **caractérisé en ce que** chaque collecteur (3a, 3b) se présente sous la forme d'un caisson parallélépipédique étanche qui s'étend dans la largeur de la plaque alvéolaire (21).

5. Panneau solaire hybride (P) selon l'une des revendications 1 à 4, **caractérisé en ce que** chaque collecteur (3a, 3b) est équipé d'un connecteur (4a, 4b) non-coudé orienté vers l'extérieur du panneau (P), lesdits connecteurs (4a, 4b) étant décalés l'un par rapport à l'autre.

6. Panneau solaire hybride (P) selon l'une des revendications 1 à 5, **caractérisé en ce que** la profondeur des collecteurs (3a, 3b) est supérieure à la hauteur des canaux internes (22).

7. Panneau solaire hybride (P) selon l'une des revendications 1 à 6, **caractérisé en ce qu'**il est constitué par l'empilement successif des éléments suivants, agencés de la face avant (12) du module photovoltaïque (1) vers la paroi inférieure (21b) de l'échangeur (2) :
- une couche ou plaque d'un matériau transparent (1d) définissant la face avant (12) du module photovoltaïque (1),
- une première couche d'un matériau encapsulant (1c) en contact intime avec la couche ou plaque de matériau transparent (1d),
- au moins un élément photovoltaïque en contact intime avec la première couche de matériau encapsulant (1c),
- une seconde couche d'un matériau encapsulant (1b) en contact intime avec au moins un élément photovoltaïque,
- la plaque alvéolaire (21) en contact intime avec la seconde couche de matériau encapsulant (1b),
- une couche ou plaque d'un matériau isolant (8) en contact intime avec ladite plaque alvéolaire (21).

8. Panneau solaire hybride (P) selon l'une des revendications 1 à 7, **caractérisé en ce que** les canaux internes (22) ont une largeur comprise entre 4 mm et 6 mm et une hauteur comprise entre 4 mm et 6 mm.

9. Panneau solaire hybride (P) selon l'une des revendications 1 à 8, **caractérisé en ce que** la paroi supérieure (21a) de la plaque alvéolaire (21), a une épaisseur inférieure à 1 mm.

10. Panneau solaire hybride (P) selon l'une des revendications 1 à 9, **caractérisé en ce que** la paroi inférieure (21b) a une épaisseur supérieure à celle de la paroi supérieure (21a).

11. Panneau solaire hybride (P) selon l'une des revendications 1 à 10, **caractérisé en ce qu'**une plaque isolante supplémentaire (8) est placée contre la paroi inférieure (21b) de la plaque alvéolaire (21).

12. Panneau solaire hybride (P) selon la revendication 11, **caractérisé en ce que** l'échangeur thermique (2) et le module photovoltaïque (1) sont maintenus en place par un cadre (6), ledit cadre (6) comprenant des moyens de pression (9) pour que la plaque isolante supplémentaire (8) soit contrainte contre la paroi inférieure (21b) de la plaque alvéolaire (21) de sorte que toute la surface de la paroi supérieure (21a) de cette dernière soit plaquée contre la face arrière (11) du module photovoltaïque (1).

13. Panneau solaire hybride (P) selon l'une des revendications 1 à 6, **caractérisé en ce que** l'échangeur thermique (2) et le module photovoltaïque (1) sont maintenus en place par un cadre (6), ledit cadre (6) comprenant des moyens de pression (9) directement en appui sur la plaque alvéolaire (21).

14. Panneau solaire hybride (P) selon l'une des revendications 1 à 13, **caractérisé en ce qu'**une couche (7) de gel est placée entre la zone d'échange thermique (ZE) et le module photovoltaïque (1).

15. Procédé de fabrication du panneau solaire hybride (P) selon la revendication 1 comprenant les étapes consistant à :
- utiliser une plaque alvéolaire (21) en matériau plastique obtenue par un procédé d'extrusion ou par moulage et dont les canaux (22) débouchent latéralement au niveau des extrémités latérales (24a, 24b) de ladite plaque (21),
- boucher les extrémités latérales (24a, 24b) de la plaque alvéolaire (21) de manière à obturer les canaux internes (22),
- aménager les ouvertures (23a, 23b) au niveau de chaque extrémité latérale (24a, 24b) de la paroi inférieure (21b) de la plaque (21) de sorte que chaque dite ouverture (23a, 23b) débouche dans chacun des canaux (22), lesquelles ouvertures sont créées en retirant par découpe, des parties de ladite paroi inférieure (21b),
- plaquer la paroi supérieure (21a) de la plaque alvéolaire (21) contre la face arrière (11) du module photovoltaïque (1),
- maintenir en position la plaque alvéolaire (21) contre le module photovoltaïque (1),
- installer un collecteur (3a, 3b) au niveau de chacune des ouvertures (23a, 23b), lesquels collecteurs (3a, 3b) forment respectivement une zone d' arrivée (ZA) et une zone d'évacuation (ZV),
- connecter les collecteurs (3a, 3b) à un circuit d'alimentation (40) en fluide de refroidissement de sorte que le fluide s'écoule depuis la zone d'arrivée (ZA) jusqu'à la zone d'évacuation (ZV).

16. Procédé selon la revendication 15, dans lequel on bouche les extrémités latérales (24a, 24b) de la plaque alvéolaire (21) par un procédé de fusion-pressage vers l'intérieur de ladite plaque ou par apport de matière et collage et/ou soudage, ou par laser, ou par ultrasons, ou par vibration, ou par soudage à chaud.

## Patentansprüche

1. Hybrid-Solarpanel (P), welches umfasst:
- ein Photovoltaikmodul (1), das eine Vorderseite (12) und eine Rückseite (11) aufweist,
- einen Wärmetauscher (2), der gegenüber der Rückseite (11) des Photovoltaikmoduls (1) angeordnet ist,
- ein Kühlfluid, das in dem Wärmetauscher (2) zirkuliert, um die Wärme des Photovoltaikmoduls (1) aufzunehmen,
- wobei der Wärmetauscher (2) einen Wärmeaustauschbereich (ZE) aufweist, der unter dem Photovoltaikmodul (1) angeordnet ist und in dem das Kühlfluid fließt, wobei dieses Fluid zwischen einem Eintrittsbereich (ZA) und einem Auslassbereich (ZV) fließt,
- innere Kanäle (22), die sich über die gesamte Fläche des Austauschbereichs (ZE) erstrecken,
- wobei der Wärmeaustauschbereich (ZE) von einer doppelwandigen Hohlkammerplatte (21) gebildet wird, diese Hohlkammerplatte (21) aus einer oberen Wand (21a) und einer unteren Wand (21b) besteht, die sich zwischen zwei seitlichen Enden (24a, 24b) der Platte (21) erstrecken und zwischen denen Hohlkammern angeordnet sind, und diese Hohlkammern in der Form von benachbarten inneren Kanälen (22) vorliegen, welche mit dem Eintritts- (ZA) und dem Auslassbereich (ZV) in Fluidverbindung stehen,
**dadurch gekennzeichnet, dass**:
- die seitlichen Enden (24a, 24b) abgedichtet sind, wobei diese seitlichen Enden (24a, 24b) und zwei Längsränder (26a, 26b) die Hohlkammerplatte (21) begrenzen,
- die Hohlkammerplatte (21) eine erste Öffnung (23a) aufweist, die in der unteren Wand (21b) angeordnet ist und die in jeden der inneren Kanäle (22) mündet, um jeden Kanal (22) mit dem Eintrittsbereich (ZA) in Fluidverbindung zu bringen, und eine zweite Öffnung (23b), die in der unteren Wand (21b) angeordnet ist und die in jeden der inneren Kanäle (22) mündet, um jeden Kanal (22) mit dem Auslassbereich (ZV) in Fluidverbindung zu bringen,
- jede der Öffnungen (23a, 23b) eine rechteckige Form aufweist, welche sich in der Breite der Hohlkammerplatte (21) parallel zu den abgedichteten seitlichen Enden (24a, 24b) und senkrecht zu den Längsrändern (26a, 26b) der Platte (21) erstreckt,
- der Eintritts- (ZA) und der Auslassbereich (ZV) in der Form von Sammelleitungen (3a, 3b) vorliegen, die auf der unteren Wand (21b) der Hohlkammerplatte (21) an den Öffnungen (23a, 23b) angeordnet sind, so dass die obere Wand (21a) dieser Letzteren auf ihrer gesamten Oberfläche eben bleibt.

2. Hybrid-Solarpanel (P) nach Anspruch 1, **dadurch gekennzeichnet, dass** der Wärmetauscher aus Polypropylen hergestellt ist.

3. Hybrid-Solarpanel (P) nach einem der Ansprüche 1 oder 2, **dadurch gekennzeichnet, dass** jede Sammelleitung (3a, 3b) an einer der Öffnungen (23a, 23b) an die Hohlkammerplatte (21) angeschweißt ist.

4. Hybrid-Solarpanel (P) nach einem der Ansprüche 1 bis 3, **dadurch gekennzeichnet, dass** jede Sammelleitung (3a, 3b) in der Form eines dichten quaderförmigen Kastens vorliegt, welcher sich in der Breite der Hohlkammerplatte (21) erstreckt.

5. Hybrid-Solarpanel (P) nach einem der Ansprüche 1 bis 4, **dadurch gekennzeichnet, dass** jede Sammelleitung (3a, 3b) mit einem nicht abgewinkelten Verbindungsstück (4a, 4b) ausgestattet ist, das zur Außenseite des Panels (P) hin gerichtet ist, wobei die Verbindungsstücke (4a, 4b) zueinander versetzt sind.

6. Hybrid-Solarpanel (P) nach einem der Ansprüche 1 bis 5, **dadurch gekennzeichnet, dass** die Tiefe der Sammelleitungen (3a, 3b) größer als die Höhe der inneren Kanäle (22) ist.

7. Hybrid-Solarpanel (P) nach einem der Ansprüche 1 bis 6, **dadurch gekennzeichnet, dass** es aus dem Stapel der folgenden, von der Vorderseite (12) des Photovoltaikmoduls (1) zur unteren Wand (21b) des Wärmetauschers (2) hin aufeinanderfolgend angeordneten Elemente besteht:
- einer Schicht oder Platte aus einem transparenten Material (1d), welche die Vorderseite (12) des Photovoltaikmoduls (1) definiert,
- einer ersten Schicht aus einem Umhüllungsmaterial (1c), die sich in innigem Kontakt mit der Schicht oder Platte aus transparentem Material (1d) befindet,
- wenigsten einem Photovoltaikelement, das sich in innigem Kontakt mit der ersten Schicht aus Umhüllungsmaterial (1c) befindet,
- einer zweiten Schicht aus einem Umhüllungsmaterial (1b), die sich in innigem Kontakt mit wenigsten einem Photovoltaikelement befindet,
- der Hohlkammerplatte (21), die sich in innigem Kontakt mit der zweiten Schicht aus Umhüllungsmaterial (1b) befindet,
- einer Schicht oder Platte aus einem Isoliermaterial (8), die sich in innigem Kontakt mit der Hohlkammerplatte (21) befindet.

8. Hybrid-Solarpanel (P) nach einem der Ansprüche 1 bis 7, **dadurch gekennzeichnet, dass** die inneren Kanäle (22) eine Breite zwischen 4 mm und 6 mm und eine Höhe zwischen 4 mm und 6 mm aufweisen.

9. Hybrid-Solarpanel (P) nach einem der Ansprüche 1 bis 8, **dadurch gekennzeichnet, dass** die obere Wand (21a) der Hohlkammerplatte (21) eine Dicke von weniger als 1 mm aufweist.

10. Hybrid-Solarpanel (P) nach einem der Ansprüche 1 bis 9, **dadurch gekennzeichnet, dass** die untere Wand (21b) eine Dicke aufweist, die größer als diejenige der oberen Wand (21a) ist.

11. Hybrid-Solarpanel (P) nach einem der Ansprüche 1 bis 10, **dadurch gekennzeichnet, dass** eine zusätzliche isolierende Platte (8) an der unteren Wand (21b) der Hohlkammerplatte (21) anliegend angeordnet ist.

12. Hybrid-Solarpanel (P) nach Anspruch 11, **dadurch gekennzeichnet, dass** der Wärmetauscher (2) und das Photovoltaikmodul (1) von einem Rahmen (6) in ihrer Position gehalten werden, wobei der Rahmen (6) Druckmittel (9) umfasst, damit die zusätzliche isolierende Platte (8) gegen die untere Wand (21b) der Hohlkammerplatte (21) verspannt wird, so dass die gesamte Fläche der oberen Wand (21a) dieser Letzteren an die Rückseite (11) des Photovoltaikmoduls (1) angedrückt wird.

13. Hybrid-Solarpanel (P) nach einem der Ansprüche 1 bis 6, **dadurch gekennzeichnet, dass** der Wärmetauscher (2) und das Photovoltaikmodul (1) von einem Rahmen (6) in ihrer Position gehalten werden, wobei der Rahmen (6) Druckmittel (9) umfasst, die direkt an der Hohlkammerplatte (21) anliegen.

14. Hybrid-Solarpanel (P) nach einem der Ansprüche 1 bis 13, **dadurch gekennzeichnet, dass** eine Gelschicht (7) zwischen dem Wärmeaustauschbereich (ZE) und dem Photovoltaikmodul (1) angeordnet ist.

15. Verfahren zur Herstellung eines Hybrid-Solarpanels (P) nach Anspruch 1, welches die folgenden Schritte umfasst:
- Verwenden einer Hohlkammerplatte (21) aus Kunststoff, die durch ein Extrusionsverfahren oder durch Formen erhalten wurde und deren Kanäle (22) seitlich an den seitlichen Enden (24a, 24b) der Platte (21) münden,
- Abdichten der seitlichen Enden (24a, 24b) der Hohlkammerplatte (21), um so die inneren Kanäle (22) zu verschließen,
- Anordnen der Öffnungen (23a, 23b) an jedem seitlichen Ende (24a, 24b) der unteren Wand (21b) der Platte (21), so dass jede solche Öffnung (23a, 23b) in jeden der Kanäle (22) mündet, wobei die Öffnungen erzeugt werden, indem Teile der unteren Wand (21b) durch Ausschneiden entfernt werden,
- Andrücken der oberen Wand (21a) der Hohlkammerplatte (21) an die Rückseite (11) des Photovoltaikmoduls (1),
- Halten der Hohlkammerplatte (21) in ihrer am Photovoltaikmodul (1) anliegenden Position,
- Einbauen einer Sammelleitung (3a, 3b) an jeder der Öffnungen (23a, 23b), wobei die Sammelleitungen (3a, 3b) einen Eintrittsbereich (ZA) bzw. einen Auslassbereich (ZV) bilden,
- Verbinden der Sammelleitungen (3a, 3b) mit einem Kreislauf zur Versorgung (40) mit Kühlfluid, so dass das Fluid vom Eintrittsbereich (ZA) bis zum Auslassbereich (ZV) fließt.

16. Verfahren nach Anspruch 15, wobei die seitlichen Enden (24a, 24b) der Hohlkammerplatte (21) durch ein Verfahren des Schmelzpressens der Platte nach innen oder durch Materialzuführung und Kleben und/oder Schweißen oder durch Laser oder durch Ultraschall oder durch Schwingungen oder durch Heißsiegeln abgedichtet werden.

## Claims

1. A hybrid solar panel (P) comprising:
- a photovoltaic module (1) comprising a front face (12) and a rear face (11),
- a heat exchanger (2) arranged opposite the rear face (11) of said photovoltaic module (1),
- a cooling fluid circulating in said heat exchanger (2) in such a way as to recuperate the heat of said photovoltaic module (1),
- the heat exchanger (2) comprising a heat exchange region (ZE) arranged beneath said photovoltaic module (1) and wherein the cooling fluid flows, which fluid flows between an inlet zone (ZA) and a discharge zone (ZV),
- inner channels (22) extending over the entire surface of the exchange region (ZE),
- the heat exchange region (ZE) is formed by a double-walled honeycomb plate (21), wherein the honeycomb plate (21) consists of an upper wall (21a) and a lower wall (21b) extending between two lateral ends (24a, 24b) of said plate (21) and where between are arranged cells, wherein the cells are in the form of adjacent inner channels (22), which are in fluidic communication with the inlet (ZA) and discharge (ZV) zones,
**characterized by the fact that:**
- the lateral ends (24a, 24b) are blocked, said lateral ends (24a, 24b), the lateral ends (24a, 24b) and two longitudinal edges (26a, 26b) delimiting the honeycomb plate (21),
- the honeycomb plate (21) comprises a first openings (23a) arranged in the lower wall (21b) and that lead into each of the inner channels (22) to place in fluidic communication each channel (22) with the inlet zone (ZA) and a second opening (23b) provided in the lower wall (21b) and that lead into each of the inner channels (22) with the discharge zone (ZV),
- each of the openings (23a, 23b) has a rectangular shape which extends in the width of the honeycomb plate (21) parallel to the blocked lateral ends (24a, 24b) and perpendicularly to the longitudinal edges (26a, 26b) of the said plate (21),
- the inlet (ZA) and discharge (ZV) zones are in the form of collectors (3a, 3b) placed along the lower wall (21b) of said honeycomb plate (21) at the openings (23a, 23b), such that the upper wall (21a) of said latter lies flat over the entire surface thereof.

2. A hybrid solar panel (P) according to claim 1, **characterized in that** the heat exchanger is made of polypropylene.

3. A hybrid solar panel (P) according to the claim 1 or 2, **characterized in that** each collector (3a, 3b) is welded to the honeycomb plate (21) at one of the openings (23a, 23b).

4. A hybrid solar panel (P) according to one of claims 1 to 3, **characterized in that** each collector (3a, 3b) is in the form of a watertight parallelepiped box which extends in the width of the honeycomb plate (21).

5. A hybrid solar panel (P) according to one of claims 1 to 4, **characterized in that** each collector (3a, 3b) is equipped with a connector (4a, 4b), which is not angled, oriented toward the outside of the panel (P), said connectors (4a, 4b) being offset from one another.

6. A hybrid solar panel (P) according to one of claims 1 to 5, **characterized in that** the depth of the collectors (3a, 3b) is greater than the height of the inner channels (22).

7. A hybrid solar panel (P) according to one of claims 1 to 6, **characterized in that** it is formed by successive stacking of the following elements, arranged from the front face (12) of the photovoltaic module (1) toward the lower wall (21b) of the exchanger (2):
- a layer or plate of a transparent material (1d) defining the front face (12) of the photovoltaic module (1),
- a first layer of an encapsulating material (1c) in intimate contact with the layer or plate of transparent material (1d),
- at least one photovoltaic element in intimate contact with the first layer of encapsulating material (1c),
- a second layer of an encapsulating material (1b) in intimate contact with at least one photovoltaic element,
- the honeycomb plate (21) in intimate contact with the second layer of encapsulating material (1b),
- a layer or plate of an insulating material (8) in intimate contact with said honeycomb plate (21).

8. A hybrid solar panel (P) according to one of claims 1 to 7, **characterized in that** the inner channels (22) have a width between 4 mm and 6 mm and a height between 4 mm and 6 mm,

9. A hybrid solar panel (P) according to one of claims 1 to 8, **characterized in that** the upper wall (21a) of the honeycomb plate (21), has a thickness less than 1 mm.

10. A hybrid solar panel (P) according to one of claims 1 to 9, **characterized in that** the lower wall (21b) has a thickness greater that the thickness of the upper wall (21a).

11. A hybrid solar panel (P) according to one of claims 1 to 10, **characterized in that** a supplementary insulating plate (8) is placed against the lower wall (21b) of the honeycomb plate (21).

12. A hybrid solar panel (P) according to claim 11, **characterized in that** the heat exchanger (2) and the photovoltaic module (1) are held in place by a frame (6), said frame (6) comprising pressure means so that the supplementary insulating plate (8) is held against the lower wall (21b) of the honeycomb plate (21) such that the entire surface of the upper wall (21a) of said latter is pressed against the rear face (11) of the photovoltaic module (1).

13. A hybrid solar panel (P) according to one of claims 1 to 6, **characterized in that** the heat exchanger (2) and the photovoltaic module (1) are held in place in a frame (6), said frame (6) comprising pressure means (9) directly against the honeycomb plate (21).

14. A hybrid solar panel (P) according to one of claims 1 to 13, **characterized in that** a layer (7) of gel is placed between the heat exchange region (ZE) and the photovoltaic module (1).

15. A method of manufacturing a hybrid solar panel (P) according to claim 1 comprising steps consisting of:
- using a honeycomb plate (21) in plastic material obtained by an extrusion process or by molding and the channels (22) of which laterally lead into the lateral ends (24a, 24b) of said plate (21),
- blocking the lateral ends (24a, 24b) of the honeycomb plate (21) in such a way as to seal the inner channels (22),
- arranging an opening (23a, 23b) at each lateral end (24a, 24b) of the lower wall (21b) of the plate (21) such that each said opening (23a, 23b) leads into each of the channels (22), wherein openings are being formed by removing through cutting of the parts from the lower wall (21b),
- pressing the upper wall (21a) of the honeycomb plate (21) against the rear face (11) of the photovoltaic module (1),
- holding the honeycomb plate (21) in position against the photovoltaic module (1),
- installing a collector (3a, 3b) at each of the openings (23a, 23b), wherein the collectors (3a, 3b) form respectively an inlet zone (ZA) and a discharge zone (ZV),
- connecting the collectors (3a, 3b) to a cooling fluid supply circuit (40) such that the fluid flows from the inlet zone (ZA) to the discharge zone (ZV).

16. A method of manufacturing according to claim 15, wherein the lateral ends (24a, 24b) of the honeycomb plate (21) are blocked by a melting-pressing process toward the interior of the plate (21) or by adding material and gluing and/or welding, or by laser, or by ultrasounds, or by vibration, or even by compression heat-sealing.
